Europäisches Patentamt

European Patent Office

Office européen des brevets

(11) Veröffentlichungsnummer: **0 310 892**
**A1**

# (12) EUROPÄISCHE PATENTANMELDUNG

(21) Anmeldenummer: **88115715.0**

(22) Anmeldetag: **23.09.88**

(51) Int. Cl.4: **G01R 31/34 , H02P 7/62**

(30) Priorität: **08.10.87 DE 3734071**

(43) Veröffentlichungstag der Anmeldung:
**12.04.89 Patentblatt 89/15**

(84) Benannte Vertragsstaaten:
**AT CH DE FR GB IT LI SE**

(71) Anmelder: **Siemens Aktiengesellschaft Berlin und München**
**Wittelsbacherplatz 2**
**D-8000 München 2(DE)**

(72) Erfinder: **Trenkler, Gerhard, Prof.**
**Am Weissen Kamp 7 d**
**D-3300 Braunschweig(DE)**
Erfinder: **Wedekind, Reinhard, Dipl.-Ing.**
**Görlitzer Strasse 16**
**D-2000 Hamburg 70(DE)**
Erfinder: **Maier, Reinhard, Dr.**
**Anna-Hermann-Strasse 54**
**D-8522 Herzogenaurach(DE)**

(54) **Anordnung zur Messung des Schlupfes elektrischer Induktionsmaschinen.**

(57) Die Erfindung bezieht sich auf eine Anordnung zur Messung des Schlupfes elektrischer Induktionsmaschinen. Zur Bestimmung des relativen Maßes für den Unterschied zwischen Drehfeld-und Rotordrehzahl von Induktionsmaschinen werden die Nichtlinearitätseffekte der Magnetisierungskennlinien von ferromagnetischen Werkstoffen ausgenutzt. An den Klemmen von Induktionsmaschinen sind unter anderem schlupfproportionale Strom- und/oder Spannungssignale nachweisbar, die durch geeignete Signalverarbeitungsmaßnahmen wie Frequenzumsetzung und Filterung ein frequenzproportionales Maß für den Schlupf liefern, das einer Messung oder Weiterverarbeitung zugeführt werden kann.

FIG 2

## Anordnung zur Messung des Schlupfes elektrischer Induktionsmaschinen

Die Erfindung betrifft eine Anordnung zur Messung des Schlupfes elektrischer Induktionsmaschinnan nach dem Oberbegriff des Anspruches 1.

Die hier genannte Meß- und Verarbeitungsanordnung soll in der Lage sein, den Schlupf von Induktionsmaschinen in ihrem Betriebsbereich direkt anzuzeigen oder einer Weiterverarbeitung zugänglich zu machen.

Der Schlupf ist ein relatives Maß für den Unterschied zwischen Drehfeld- und Rotordrehzahl und somit eine wichtige Betriebsgröße für Induktionsmaschinen.

Es sind Anordnungen bekannt, die entweder die Drehzahl messen (Trenkler, G. "Die elektrische Messung von Drehzahl und Winkelgeschwindigkeit", Verlag E. Geyer, Bad Wörishofen, 1974, insbesondere Seite 36 und 37) um so den Schlupf berechenbar zu machen oder bei Wechselrichterversorgung eines Motors den Schlupf mittels eines Schlupfrechners aus Motorstrom, Motorfluß und Zündwinkel berechnen (DE-OS 35 23 619). Weiterhin bekannt sind rechnergestützte Schätzverfahren (Hillenbrand, F., "Identifikation linearer zeitinvarianter Systeme und ihre Anwendung auf Induktionsmaschinen", Dissertation, TU Berlin 1982, Seite 149 - 157).

Zur Schlupfmessung ist es auch bekannt (CH-A-449 770) eine gesonderte Meßmaschine vorzusehen, in deren Luftspalt Hallsonden angeordnet sind.

Weiterhin ist es zur Drehzahlerfassung bei Universalmotoren unter Ausnutzung von Nutzungsoberschwingungen bekannt (FR-A-25 55 317) die Fast-Fourier-Transformation anzuwenden.

Diese Anordnungen und Verfahren erfordern Drehzahlsensoren oder sind nur für bestimmte Maschinentypen sowie Schaltungsvarianten geeignet oder erfordern genaue Vorkenntnisse über das Meßobjekt. Der Aufwand für Auswerteelektronik und -software ist im allgemeinen erheblich.

Es ist auch vorgeschlagen worden (P 37 11 976.1 vom 09.04.1987), zur Drehzahlermittlung eine Meßanordnung vorzusehen, die die zeitlichen Verläufe der Spannungen an den elektrischen Anschlüssen und/oder der Ströme durch die elektrischen Anschlüsse der Maschine erfaßt.

Aufgabe dieser Erfindung ist es, eine Anordnung zu schaffen, die auf universelle und einfache Weise die Messung des Schlupfes von elektrischen Induktionsmaschinen ermöglicht.

Diese Aufgabe wird bei einer gattungsgemäßen Anordnung durch die kennzeichnenden Merkmale des Anspruchs 1 gelöst. Weiterbildung und vorteilhafte Ausgestaltungen sind den Unteransprüchen zu entnehmen.

Die Erfindung wird anhand der Zeichnungen näher erläutert. Es zeigen:

FIG 1 ein Blockschaltbild einer Ausführungsmöglichkeit unter Verwendung eines Stromsignals,

FIG 2 ein solches unter Verwendung eines Spannungssignals.

Vor der Beschreibung dieser beiden Ausführungsmöglichkeiten folgt zunächst eine Erklärung des gemeinsamen Prinzips.

In Induktionsmaschinen finden ferromagnetische Werkstoffe Verwendung, deren Magnetisierungskennlinien auch im normalen Arbeitsbereich, also außerhalb der Sättigung, nichtlinear verlaufen. Es erfolgt so eine multiplikative Verknüpfung von schlupf- und netzfrequenten Flußanteilen und es entstehen Kombinationsfrequenzen, die durch Induktion an den Klemmen der Maschine als Strom- und/oder Spannungssignale nachweisbar sind. Diese Komponenten erscheinen im Signalspektrum als Frequenzgruppen im Abstand der doppelten bzw. der einfachen Schlupffrequenz um die Netzfrequenz sowie ihrer ungeradzahligen und geradzahligen Harmonischen. Die Amplitude dieser Komponenten ist unter anderem magnetwerkstoff- und sättigungsgradabhängig, üblicherweise jedoch sehr klein (ca. -60 bis -90 dB), bezogen auf die Netzgrößen. Da sie, besonders bei kleinem Schlupf, sehr nahe bei der Netzfrequenz bzw. ihrer Harmonischen liegen, ist eine direkte Selektion und Auswertung nicht möglich.

Möglich ist jedoch die Selektion einer oder mehrerer geeigneter Frequenzgruppen. Unerwünschte Signalkomponenten, wie etwa die Nutungsoberschwingungen, sollen hierbei ausreichend unterdrückt werden. Wenn nun die schlupfproportionalen Komponenten durch Faltung im Frequenzbereich in ein ungestörtes Frequenzband, beispielsweise in das Basisband, verlegt werden, können sie wegen des hier vorhandenen großen relativen Frequenzabstandes zu Störkomponenten durch einfache Filterung gewonnen werden. Sie können nun kontinuierlich direkt angezeigt und/oder weiterverarbeitet werden.

So kann beispielsweise eine Frequenzgruppe mit Komponenten im Abstand der doppelten Schlupffrequenz 2.fs selektiert werden. Nach Faltung und Filterung kann dann ein Frequenzzähler zur Anzeige verwendet werden. Bei einem 50 Hz-Netz wird dann, unabhängig von der Polpaarzahl der Maschine, direkt der Schlupf s in Prozent angezeigt, denn es gilt 2.fs = 2.s.50 = 100.s = s (%).

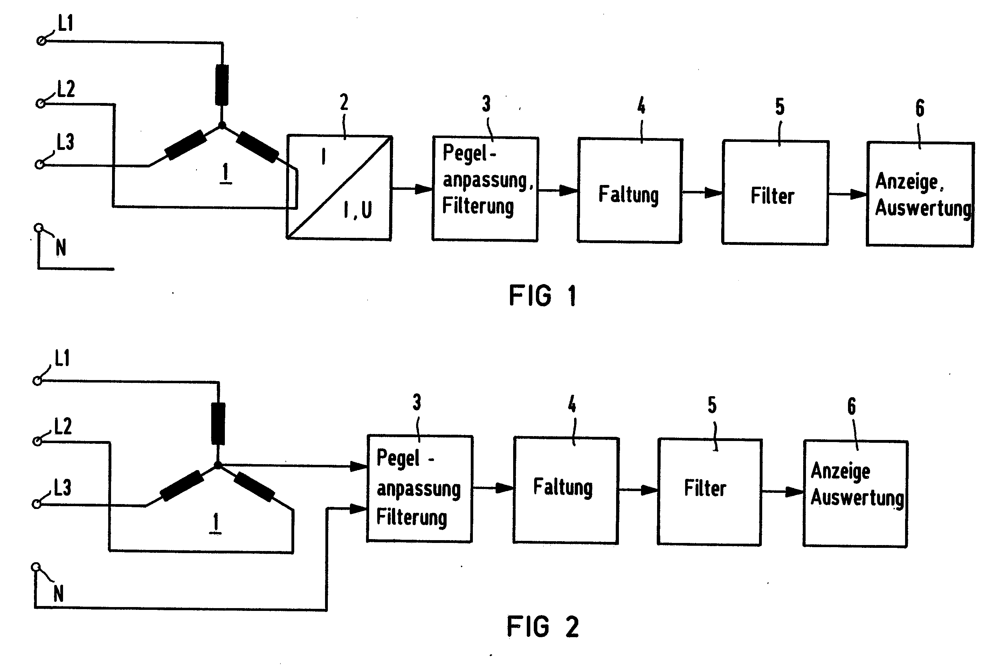

In der Anordnung gemäß FIG 1 wird von einer ein- oder mehrphasigen Induktionsmaschine 1 mittels mindestens eines Wand lers 2 aus mindestens einer Phase das Rohsignal gewonnen, das aus der geometrischen Summe aller vom Netz gelieferten und von der Maschine erzeugten Komponenten besteht. Es wird einem pegelangepaßten Vorfilter 3 mit vorzugsweise Bandpaßcharakteristik zugeführt. Die anschließende Faltung 4 (siehe E. Oran Brigham, "FFT Schnelle Fourier-Transformation", Seiten 68 bis 94, 2. Auflage, R. Oldenbourg Verlag München Wien 1985) erfolgt vorteilhaft durch einfache Quadrierung oder Synchrongleichrichtung mit der Netzfrequenz. Hierfür können bekannte Einrichtungen wie beispielsweise Parabelfunktionsnetzwerke, Multiplizierer oder Ringmodulatoren Verwendung finden. Mittels eines Filters 5 werden unerwünschte Frequenzkomponenten des gefalteten Signals unterdrückt. Da die Amplitude des Nutzsignals bei zunehmendem Schlupf wegen der ebenfalls größer werdenden Rückwirkung des Läufers steigt, kann durch geeignete Wahl der Eigenschaften des Filters 5 ein nahezu konstantes Ausgangssignal erzeugt werden. Derartige Filter sind beispielsweise aus der Druckschrift Stearns, "Adaptive Signal Processing" Prentice-Hall, Inc. Englewood Cliffs, NJ 07632, Seite 316 ff bekannt.

Ist das Filter 5 beispielsweise als Tiefpaßfilter ausgeführt, so kann bei geeigneter Wahl von Eckfrequenz und Flankensteilheit in den meisten Anwendungsfällen auf Pegelregelungs- oder -begrenzungseinrichtungen verzichtet werden, so daß das Ausgangssignal direkt der Anzeige- bzw. Auswerteeinheit 6 zugeführt werden kann.

FIG 2 zeigt eine weitere Möglichkeit, das Rohsignal zu gewinnen. Wird eine dreiphasige Maschine 1 in Sternschaltung betrieben, besteht die Möglichkeit, auf den Wandler 2 zu verzichten, wenn der Maschinensternpunkt nicht mit dem Netzsternpunkt verbunden ist. Da sich die Nutzsignalkomponenten wegen mangelnder Symmetrie im Sternpunkt nicht auslöschen, stehen sie hier direkt als Spannungssignal gegen den Netzsternpunkt zur Verfügung. Die weitere Verarbeitung entspricht der von FIG 1.

**Ansprüche**

1. Anordnung zur Messung des Schlupfes einer elektrischen Induktionsmaschine mittels einer Meß- und Verarbeitungsanordnung, **dadurch gekennzeichnet,** daß einer Funktionsstufe (3) zur Pegelanpassung und Vorfilterung, der die von der Maschine (1) erzeugten, in ihrer Frequenz dem Schlupf proportionalen Strom- und/oder Spannungssignale zugeführt werden, eine Einrichtung zur Faltung des Signals im Frequenzbereich an der Netzfrequenz und/oder ihrer Harmonischen (4), ein Filter (5) sowie eine Anzeige- und/oder Auswerteeinheit nachgeschaltet sind (FIG 1 und 2).

2. Anordnung nach Anspruch 1, **dadurch gekennzeichnet,** daß der Funktionsstufe (3) ein Wandler (2) vorgeschaltet ist, durch den die von einer ein- oder mehrphasigen Induktionsmaschine erzeugten schlupfproportionalen Stromsignale aus mindestens einer Phase gewonnen werden (FIG 1).

3. Anordnung nach Anspruch 1, **dadurch gekennzeichnet,** daß der Eingang der Funktionsstufe (3) zwischen Netzsternpunkt und dem mit diesem nicht verbundenen Sternpunkt der Maschine zur Abnahme der von einer mehrphasigen Induktionsmaschine in Sternschaltung erzeugten schlupfproportionalen Spannungssignale geschaltet ist (FIG 2).

4. Anordnung nach einem der Ansprüche 1 bis 3, **dadurch gekennzeichnet,** daß das Filter (5) durch Wahl der Filterparameter so ausgelegt ist, daß der Anzeige- und Auswerteeinheit (6) ein Signal mit nahezu konstanter, schlupfunabhängiger Amplitude zugeführt wird.

EP 0 310 892 A1

L1

L2

L3

N

1

2
I / I,U

3
Pegelanpassung,
Filterung

4
Faltung

5
Filter

6
Anzeige,
Auswertung

**FIG 1**

L1

L2

L3

N

1

3
Pegelanpassung
Filterung

4
Faltung

5
Filter

6
Anzeige
Auswertung

**FIG 2**

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int. Cl.4) |
|---|---|---|---|
| D,A | US-A-4 562 396 (P.M. ESPELAGE et al.) * DE-A-3 523 619 * | | G 01 R 31/34 H 02 P 7/62 |
| A | EP-A-0 181 775 (BONAR BRAY LTD) | | |
| D,A | CH-A- 449 770 (BBC) * Insgesamt * | 1 | |
| A | IEEE TRANSACTIONS ON POWER ELECTRONICS, Band PE-2, Nr. 3, Juli 1987, Seiten 257-263, IEEE, New York, US; M. ISHIDA et al.: "Steady-state characteristics of a torque and speed control system of an induction motor utilizing rotor slot harmonics for slip frequency sensing" | | |
| A | IEEE TRANSACTIONS ON INDUSTRY AND GENERAL APPLICATIONS, Band IGA-7, Nr. 6, November/Dezember 1971, Seiten 713-717, IEEE, New York, US; M.S. ERLICKI et al.: "Leakage field changes of an induction motor as indication of nonsymmetric supply" | | RECHERCHIERTE SACHGEBIETE (Int. Cl.4)  G 01 R 31/00 H 02 P |
| D,A | FR-A-2 555 317 (BLACK & DECKER) * Figur 2; Zusammenfassung * & US-A-4 527 101 | 1 | |
| A | DE-A-3 234 683 (ROBERT BOSCH GmbH) | | |

Der vorliegende Recherchenbericht wurde für alle Patentansprüche erstellt

| Recherchenort | Abschlußdatum der Recherche | Prüfer |
|---|---|---|
| DEN HAAG | 09-01-1989 | BEYER F. |